# EUROPÄISCHE PATENTSCHRIFT

(11) **EP 1 127 366 B1**
(45) Veröffentlichungstag und Bekanntmachung des Hinweises auf die Patenterteilung: **20.07.2005**
(21) Anmeldenummer: 99947272.3
(22) Anmeldetag: 01.09.1999
(51) Int. Cl.: H01J 37/32

(54) **VORRICHTUNG ZUR PLASMATECHNISCHEN ABSCHEIDUNG VON POLYKRISTALLINEM DIAMANT**
DEVICE FOR THE PLASMA DEPOSITION OF A POLYCRYSTALLINE DIAMOND
DISPOSITIF DE SEPARATION AU PLASMA D'UN DIAMANT POLYCRISTALLIN

(30) Priorität: 12.09.1998 DE 19841777
(43) Veröffentlichungstag der Anmeldung: 29.08.2001
(73) Patentinhaber: Unaxis Deutschland Holding GmbH, 81476 München (DE); Fraunhofer-Gesellschaft zur Förderung der angewandten Forschung e.V., 80686 München (DE)
(72) Erfinder: LIEHR, Michael, D-36325 Feldatal (DE); SCHÄFER, Lothar, D-38527 Meine (DE)
(86) Internationale Anmeldenummer: PCT/EP1999/006397
(87) Internationale Veröffentlichungsnummer: WO 2000/016374

(56) Entgegenhaltungen:
- EP-A- 0 823 493
- DE-A- 19 628 949
- DE-C- 19 503 205

## Beschreibung

Die Erfindung betrifft eine Vorrichtung zur plasmatechnischen Abscheidung von polykristallinem Diamant auf großflächigen plattenförmigen Substraten mit einer Vakuumkammer, mit einer Schleuse zum Ein- und Ausschleusen der Substrate und mit einer in der Vakuumkammer angeordneten Einrichtung zum Fördern der Substrate durch die Vakuumkammer.

Eine bekannte Vorrichtung zur Erzeugung von Plasma (DE 195 03 205) ermöglicht es, in einem begrenzten Betriebsbereich (Prozeßbereich, Gasdruck, Mikrowellenleistung) Plasmen für Oberflächenbehandlungen und Beschichtungstechnik zu erzeugen. Die bekannte Vorrichtung besteht im wesentlichen aus einem in einer Vakuumprozeßkammer installierten zylindrischen Glasrohr und einem darin befindlichen metallisch leitenden Rohr, wobei im Innenraum des Glasrohrs Atmosphärendruck herrscht. Mikrowellenleistung wird beidseitig durch zwei Einspeisungen und zwei metallische Koaxialleitungen, bestehend aus Innenleiter und Außenleiter, durch die Wände der Vakuumprozeßkammer eingeleitet. Der fehlende Außenleiter der Koaxialleitung innerhalb der Vakuumprozeßkammer wird durch eine Plasmaentladung ersetzt, die bei hinreichenden Zündbedingungen (Gasdruck) durch die Mikrowellenleistung gezündet und aufrechterhalten wird, wobei die Mikrowellenleistung aus den beiden metallischen Koaxialleitungen und durch das Glasrohr in die Vakuumprozeßkammer austreten kann. Das Plasma umschließt das zylinderförmige Glasrohr von außen und bildet zusammen mit dem Innenleiter eine Koaxialleitung mit sehr hohem Dämpfungsbelag. Bei feststehender, beidseitig eingespeister Mikrowellenleistung kann der Gasdruck der Vakuumprozeßkammer so eingestellt werden, daß das Plasma augenscheinlich gleichmäßig entlang der Vorrichtung dort brennt, wo innerhalb der Vakuumprozeßkammer der Außenleiter der Koaxialleitung fehlt.

Man hat auch schon eine Vorrichtung zur Erzeugung von Plasma in einer Vakuumkammer vorgeschlagen (Patentanmeldung DE 197 22 272.2), bei der ein stabförmiger Leiter innerhalb eines Rohres aus isolierendem Werkstoff durch die Vakuumkammer geführt ist und der Innendurchmesser des Isolierrohres größer als der Durchmesser des Leiters ist, das Isolierrohr an beiden Enden in Wänden der Vakuumkammer gehalten und gegenüber den Wänden an seiner Außenfläche abgedichtet ist und der Leiter an beiden Enden jeweils an eine erste Quelle zur Erzeugung der elektromagnetischen Wechselfelder angeschlossen ist, jeweils im Bereich beider Wanddurchführungen in Richtung auf seine mittlere Partie zu zumindest ein Stück weit von einem Rohrstück aus elektrisch leitendem Werkstoff beabstandet umschlossen ist, wobei die beiden Rohrstücke konzentrisch zum Isolierrohr angeordnet und jeweils die kreisringzylinderförmigen, vom Isolierrohr und dem jeweiligen Rohrstück gebildeten Zwischenräume an eine zweite Quelle zur Erzeugung eines elektromagnetischen Wechselfeldes angeschlossen sind.

Es ist auch bereits seit langem bekannt, Diamanten auf Diamantsubstraten aufwachsen zu lassen (Vakuumbeschichtung 5, Anwendungen Teil II, Prof. Dr. G. Kienel, VDI-Verlag GmbH, Düsseldorf 1993). Darüber hinaus wurde die Bedeutung des atomaren Wasserstoffs während des Aufwachsprozesses gefunden. Weiterhin ist es auch bekannt, Diamantschichten durch Heißdraht-Verfahren (Hot Filament-Methoden) durch alle Arten von Plasma-CVD (Mikrowellen, RF, DC, Bogenentladungen, Plasmastrahl) und aus C₂H₂/O₂-Flammen abzuscheiden.

Weiterhin sind Verfahren zum Aufbringen von Diamantschichten mittels Heißdrahtquellen, insbesondere die notwendigen Parameter hierfür, wie Drücke und Prozeßgaszusammensetzungen, ausführlich beschrieben in "Properties and Growth of Diamond", Gordon Davies, Kings College, London UK, published by INSPEC, the Institution of Electrical Engineers, 1994 und in "Current and Prospective Fields of Application for Diamond Thin Films", Michael Liehr, April 1995, Department of Physics, Heriot-Watt University, Edinburgh.

Schließlich ist eine Vorrichtung zur plasmatechnischen Abscheidung von polykristallinem Diamant auf großflächigen plattenförmigen Substraten vorgeschlagen worden (Patentanmeldung DE 196 31 407), bestehend aus einer Vakuumkammer, mit Schleusen zum Ein- und Ausschleusen der Substrate, mit einer in der Kammer angeordneten Einrichtung zum Fördern der Substrate durch mindestens eine, vorzugsweise aber zwei Behandlungsstationen und mit eine erste Gruppe bildenden, oberhalb der Substratebene vorgesehenen Heißdrahtquellen und mit eine zweite Gruppe bildenden Mikrowellenplasmaquellen und mit einer unterhalb der Substratebene angeordneten, mit Radiofrequenz gespeisten Elektrode zur Erzeugung einer Vorspannung und mit in die Vakuumkammer einmündenden Gaszuleitungsrohren, wobei sich die als Linienquellen ausaebildeten Heißdrahtanordnungen quer zur Substrattransportrichtung erstrecken und eine erste Beschichtungszone bilden, wobei mit Abstand und parallel zu den Heißdrahtquellen die Mikrowellenplasmaquellen in einer Reihe angeordnet sind und zusammen eine zweite Beschichtungszone bilden.

Der vorliegenden Erfindung liegt die Aufgabe zugrunde, große ebene Substratflächen mit superharten Kohlenstoffschichten gleichmäßiger Dicke und Qualität zu belegen.

Diese Aufgabe wird gemäß Anspruch 1 gelöst durch eine Vielzahl von zueinander parallelen und in einer gemeinsamen Ebene oberhalb der Substrate angeordneten, sich quer zur Substratförderrichtung erstreckenden linienförmigen Mikrowellenplasmaquellen mit in die Prozeßkammer einmündenden Gaszuleitungs- und Gasabzugsrohren, wobei jeder der Linienquellen jeweils mehrere über die Länge der Linienquelle verteilt angeordnete Gaszuleitungs- und Gasabzugsrohre zugeordnet sind und sich die Austrittsöffnungen der Gaszuleitungsrohre jeweils unmittelbar oberhalb der Linienquelle befinden und die Öffnungen der Gasabzugrohre jeweils im Bereich zwischen zwei Linienquellen und in einer Ebene, die sich etwa durch die Seelenachsen der Linienquellen erstreckt, angeordnet sind.

Weitere Einzelheiten und Merkmale sind in den Patentansprüchen beschrieben und gekennzeichnet.

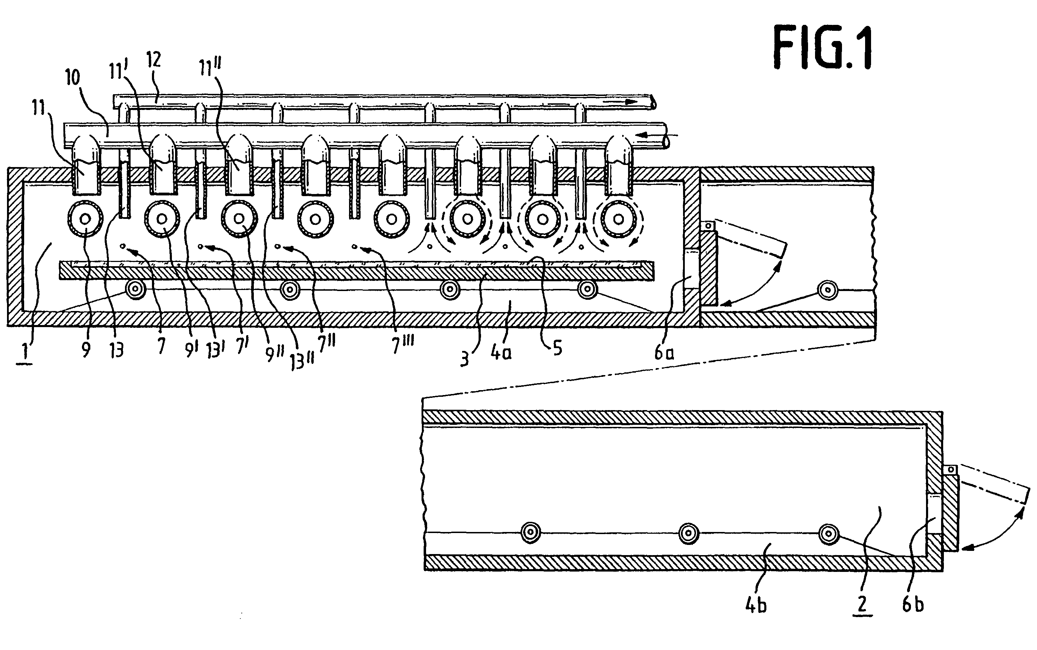

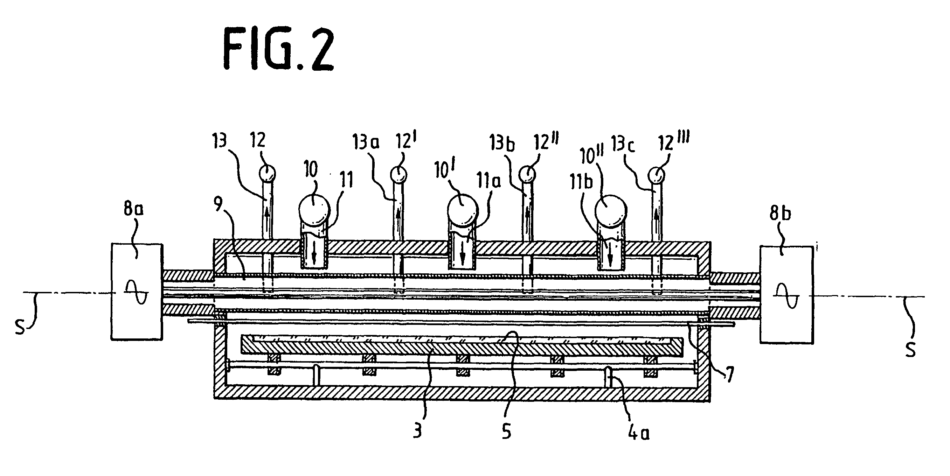

Die Erfindung läßt die verschiedensten Ausführungsmöglichkeiten zu; eine davon ist in der anhängenden Zeichnung, die Fig. 1 eine Vorrichtung rein schematisch im Längsschnitt und in Fig. 2 im Querschnitt zeigt, näher dargestellt.

Die Beschichtungsvorrichtung besteht im wesentlichen aus zwei hintereinander geschalteten Vakuumkammern 1, 2, wobei eine der Kammern die Prozeßkammer 1 bildet, den in den Kammerwänden vorgesehenen Schlitzschleusen 6a, 6b, den Transportvorrichtungen 4a, 4b, einem verfahrbaren Substratträger 3, einer Vielzahl von netzartig miteinander verbundenen Gaseinlaßrohren 11, 11'... bzw. 11a, 11b... einer entsprechenden Anzahl von netzartig verknüpften Gasabsaugrohren 13, 13'... bzw. 13a, 13b,..., den jeweils von Mikrowellensendern 8a, 8b... gespeisten linienförmigen Mikrowellenplasmaquellen 9, 9'... und einem jeder Mikrowellenplasmaquelle 9, 9'... zugeordnetem Glühdraht 7, 7',...

Die (flachen) Substrate 5 werden auf dem kühlbaren Substratträger 3 durch die Schlitzschleusen 6a und 6b mittels der Transportvorrichtungen 4a und 4b durch die Vakuumkammer 2 in die Prozeßkammer 1 eingebracht. Precursorgas wird über die Einlaßrohre 11, 11'... bzw. 10, 10'... bzw. 10a, 10b,... dem Beschichtungsprozeß zugeführt. Die für den Beschichtungsprozeß notwendige Energie wird über eine Anzahl parallel zueinander angeordneter, durch Mikrowellensender 8a und 8b gespeiste, linienförmige Mikroplasmaquellen 9, 9',... und eine Anzahl kolinear angeordneter Glühdrähte 7, 7',... eingebracht, wobei die Mikrowellenplasmaquellen 9, 9',... und die Glühdrähte 7, 7',... in alternierender Reihenfolge, vorzugsweise äquidistant angeordnet sind. Typischerweise sind die Abstände der Glühdrähte 7, 7',... zu der Substratoberfläche kleiner bemessen als die Abstände zwischen den Mikrowellenplasmaquellen 9, 9',... und dem Substrat 5. Die Glühdrähte 7, 7',... werden mittels eines Gleichspannungspotentials von elektrischen Strömen durchflossen. Die sich aus den Gleichspannungspotentialen und den Strömen ergebende Leistung wird dabei so gewählt, daß die Temperaturen der Glühdrähte zwischen 2000°C und 3000°C liegen. Die dazu notwendigen Spannungen der Ströme hängen von der Geometrie der Glühdrähte 7, 7',... (Länge und Durchmesser) und vom Glühdrahtmaterial ab. Während des Beschichtungsprozesses kann das Substrat 5 mit dem Substrathalter 3 periodisch (in Richtung des gestrichelten Doppelpfeils) bewegt werden, um die Gleichmäßigkeit des Beschichtungsprozesses zu optimieren.

Erfindungswesentlich ist, daß oberhalb der zu beschichtenden Substratfläche ein engmaschiges Netz von Gaseinlaßrohren 11, 11',... vorgesehen ist, das von einem ebenso engmaschigen Netz von Gasabsaugrohren 13, 13',... überlagert ist, wobei jeweils sowohl sich quer zu den einander parallelen Plasmaquellen 9, 9',... erstreckende Gaszuleitungs- bzw. Verbindungsrohre als sich lotrecht zur Substrat-ebene erstreckende Rohrstücke für den Gaseinlaß und für die Gasabsaugung vorgesehen sind. Das Netzwerk von Gaszuleitungs- und Gasabsaugungsrohren ist so aufgebaut, daß alle Partien des Substrats sowohl etwa gleichen Gasströmen als auch Plasmafeldern ausgesetzt sind.

## Patentansprüche

1. Vorrichtung zur plasmatechnischen Abscheidung von polykristallinem Diamant auf großflächigen plattenförmigen Substraten (5), mit einer Prozeßkammer (1), mit einer Schleuse (6a) zum Ein- und Ausschleusen der Substrate (5), mit einer in der Prozeßkammer (1) angeordneten Einrichtung (4a) zum Fördern der Substrate (5) durch die Prozeßkammer (1), mit einer Vielzahl von zueinander parallelen und in einer gemeinsamen Ebene oberhalb der Substrate (5) angeordneten, sich quer zur Substratförderrichtung erstreckenden linienförmigen Mikrowellenplasmaquellen (9, 9'...) und mit in die Prozeßkammer (1) einmündenden Gaszuleitungs- und Gasabzugsrohren (10, 10',..., 11, 11',..., 12, 12',..., 13, 13',..., 13a,...), wobei jeder der Linienquellen (9, 9',...) jeweils mehrere über die Länge der Quelle (9, 9',...) verteilt angeordnete Gaszuleitungs- und Gasabzugsrohre (10,... 11,... bzw. 12,... 13,...) zugeordnet sind und sich die Austrittsöffnungen der Gaszuleitungsrohre (11, 11',...) jeweils unmittelbar oberhalb der Linienquelle (9, 9',...) befinden, wobei die Öffnungen der Gasabzugsrohre (13, 13',...) jeweils im Bereich zwischen zwei Linienquellen (9, 9',...) und in einer Ebene, die sich etwa durch die Seelenachsen (5) der Linienquellen (9, 9',...) erstreckt, angeordnet sind.

2. Vorrichtung nach Anspruch 1, **dadurch gekenn**quer **zeichnet, daß** jeder sich quer zur Substratförderung erstreckenden Linienquelle (9, 9',...) mehrere, über die Länge der Quelle verteilt angeordnete Gaszuleitungsrohre (11, 11',...) zugeordnet sind, wobei sich die, in die Prozeßkammer (1) einmündenden Auslaßöffnungen der Gaszuleitungsrohre jeweils unmittelbar oberhalb der Linienquelle (9, 9',...) befinden und wobei jeweils eine der Anzahl der Gaszuleitungsrohre (11, 11',...) entsprechende Anzahl von Gasabzugsrohren (13, 13',...) vorgesehen sind, deren Abzugsöffnungen jeweils in den Raum zwischen zwei Linienquellen (9, 9',...) in der Ebene der Seelenachsen der Linienquellen (9, 9',...) einmünden.

3. Vorrichtung nach den Ansprüchen 1 und 2, **dadurch gekennzeichnet, daß** der Abstand von einer Linienquelle (9, 9',...) zur jeweils benachbarten Linienquelle (9, 9',...) und der Abstand vom einen Gsszuleitungsrohr (11, 11',...) zum jeweils benachbarten Gaszuleitungsrohr (11, 11',...) sowie der Abstand vom einen Gasabzugsrohr (13, 13',...) zum jeweils nächsten Gasabzugsrohr (13, 13',...) etwa gleich bemessen ist, so daß über dem in die Prozeßkammer (1) eingeschleusten Substrat (5) ein gleichmäßiges Netzwerk von Gaseinlaß-, Gasabzugsrohren und Linienquellen gebildet ist.

## Claims

1. Device for plasma deposition of polycrystalline diamond on large area plate-like substrates (5), with a process chamber (1), with a lock (6a) for introduction and extraction of the substrate (5), with a device (4a) arranged in the process chamber (1) to transport the substrate (5) through the process chamber (1), with a multiplicity of linear microwave plasma sources (9, 9'....) arranged parallel to each other in a common plane above the substrate (5) and extending transverse to the substrate transport direction, and with gas supply and gas extraction tubes (10, 10'...., 11, 11'...., 12, 12'...., 13, 13'...., 13a....) opening in the process chamber (1), where allocated to each linear source (9, 9'....) are several gas supply and gas extraction tubes (10...., 11.... or 12...., 13....) arranged distributed over the length of the source (9, 9'....) and the outlet openings of the gas supply tubes (11, 11'....) each lie directly above the linear source (9, 9'....), the extraction openings of the gas extraction tubes (13, 13'....) being arranged in the area between two linear sources (9, 9'....) and in a plane extending approximately through the core axes (5) of the linear sources (9, 9'....).

2. Device according to claim 1, **characterised in that** allocated to each linear source (9, 9'....) extending transverse to the substrate transport direction are several gas supply tubes (11, 11'....) arranged distributed over the length of the source, where the inlet openings of the gas supply tubes opening in the process chamber (1) each lie directly above the linear source (9, 9'....) and where in each case a number of gas extraction tubes (13, 13'....) corresponding to the number of gas supply tubes (11, 11'....) is provided, the extraction openings of which each open in the space between two linear sources (9, 9'....) in the plane of the core axes of the linear sources (9, 9'....).

3. Device according to claims 1 and 2, **characterised in that** the distance from one linear source (9, 9'....) to the next linear source (9, 9'....) and the distance from one gas supply tube (11, 11'....) to the next gas supply tube (11, 11'....) and the distance from one gas extraction tube (13, 13'....) to the next gas extraction tube (13, 13'....) are approximately equal, so that above the substrate (5) introduced through a lock into the process chamber (1) is formed an even network of gas inlet tubes, gas extraction tubes and linear sources.

## Revendications

1. Dispositif de dépôt dans un plasma de diamant polycristallin sur des substrats (5) en forme de plaque de grande surface, lequel dispositif comporte un chambre de traitement (1), un sas (6a) destiné à l'entrée et à la sortie des substrats (5), un dispositif (4a) placé dans la chambre de traitement (1) et destiné à transporter les substrats (5) dans la chambre de traitement (1), un grand nombre de sources de plasma à hyperfréquence linéaires (9, 9', ...) parallèles, disposées au-dessus des substrats (5) dans un plan commun et s'étendant transversalement à la direction de transport des substrats et des tubes d'amenée de gaz et d'évacuation de gaz (10, 10', ..., 11, 11', ..., 12, 12', ..., 13, 13', ..., 13a, ...) débouchant dans la chambre de traitement (1), à chacune des sources linéaires (9, 9', ...) étant associés plusieurs tubes d'amenée de gaz et d'évacuation de gaz (10, ..., 11, ... resp. 12, ..., 13, ...) répartis sur la longueur de la source (9, 9', ...) et les ouvertures de sortie des tubes d'amenée de gaz (11, 11', ...) se trouvant juste au-dessus de la source linéaire (9, 9', ...), les ouvertures des tubes d'évacuation de gaz (13, 13', ...) étant placées dans la région entre deux sources linéaires (9, 9', ...) et dans un plan qui passe à peu près par les axes de noyau (5) des sources linéaires (9, 9', ...).

2. Dispositif selon la revendication 1, **caractérisé en ce que** à chaque source linéaire (9, 9'), s'étendant transversalement à la direction de transport des substrats, sont associés plusieurs tubes d'amenée de gaz (11, 11', ...) répartis sur la longueur de la source, les ouvertures de sortie des tubes d'amenée de gaz, lesquelles débouchent dans la chambre de traitement (1), se trouvant juste au-dessus de la source linéaire (9, 9') et un nombre de tubes d'évacuation de gaz (13, 13', ...), correspondant au nombre des tubes d'amenée de gaz (11, 11', ...) étant prévus et ayant des ouvertures d'évacuation qui débouchent dans l'espace entre deux sources linéaires (9, 9', ...) dans le plan des axes de noyau des sources linéaires (9, 9', ...).

3. Dispositif selon les revendications 1 et 2, **caractérisé en ce que** la distance d'une source linéaire (9, 9', ...) à la source linéaire adjacente (9, 9', ...) et la distance d'un tube d'amenée de gaz (11, 11', ...) au tube d'amenée de gaz adjacent (11, 11', ...) ainsi que la distance d'un tube d'évacuation de gaz (13, 13', ...) au tube d'évacuation de gaz adjacent (13, 13', ...) sont sensiblement égales de sorte qu'un réseau uniforme de tubes d'amenée et d'évacuation de gaz et de sources linéaires est formé au-dessus du substrat (5) entrant dans la chambre de traitement (1).
